# EUROPEAN PATENT APPLICATION

(11) **EP 4 506 864 A1**
(43) Date of publication of application: **12.02.2025**
(21) Application number: 24179579.8
(22) Date of filing: 03.06.2024
(51) Int. Cl.: G06N 10/40

(54) **DEVICE AND METHOD WITH FREQUENCY TUNING**

(30) Priority: 10.08.2023 KR 20230104932; 21.11.2023 KR 20230162464
(71) Applicant: Samsung Electronics Co., Ltd., Suwon-si, Gyeonggi-do 16677 (KR)
(72) Inventor: Kim, Dae Yun, 16677 Suwon-si, Gyeonggi-do (KR); Jeon, In Su, 16677 Suwon-si, Gyeonggi-do (KR); Kwon, Hyeok Shin, 16677 Suwon-si, Gyeonggi-do (KR)
(74) Representative: Grünecker Patent- und Rechtsanwälte PartG mbB

(57) **Abstract**

A superconducting device includes a frequency tunable device comprising a first conductive pad and a second conductive pad that are connected to each other by a Josephson junction, a ferromagnetic structure disposed at a predetermined distance apart from the first and second conductive pads, a control line located below the ferromagnetic structure, and a control circuit configured to control a resonant frequency of the frequency tunable device by controlling current flowing through the control line.

## Description

### BACKGROUND

### 1. Field

The following description relates to a frequency tunable device and a superconducting device including the same.

### 2. Description of Related Art

Quantum computers may be computational machinery that depend on or use quantum mechanical phenomena, such as quantum superposition and quantum entanglement, as operating principles to perform data processing. A unit element capable of storing information using a quantum mechanical principle, or the information itself, is called a quantum bit or qubit, which can be used as a basic unit of information in a quantum computer.

Qubits may be implemented in various ways, such as photon qubits, ion trap qubits, topological qubits, and superconducting qubits.

### SUMMARY

This summary is provided to introduce a selection of concepts in a simplified form that are further described below in the Detailed Description. This summary is not intended to identify key features or essential features of the claimed subject matter, nor is it intended to be used as an aid in determining the scope of the claimed subject matter.

The invention is what is claimed in the independent claims. Preferred embodiments are specified in the dependent claims.

In one or more general aspects, a superconducting device includes: a frequency tunable device comprising a first conductive pad and a second conductive pad that are connected to each other by a Josephson junction; a ferromagnetic structure disposed at a predetermined distance apart from the first and second conductive pads; a control line located below the ferromagnetic structure; and a control circuit configured to control a resonant frequency of the frequency tunable device by controlling current flowing through the control line.

The frequency tunable device may include either one or both of a tunable qubit coupler and a tunable qubit.

The control circuit may be configured to reverse a magnetization alignment direction of the ferromagnetic structure by applying a current exceeding a predetermined threshold to the control line to induce a spin-orbit torque (SOT) phenomenon in the ferromagnetic structure.

For the applying of the current exceeding the predetermined threshold, the control circuit may be configured to apply the current exceeding the predetermined threshold in the form of a pulse only once.

For the applying of the current exceeding the predetermined threshold, the control circuit may be configured to apply the current exceeding the predetermined threshold value in an opposite direction to a direction of a current during the formation of the magnetization alignment direction to reverse the formed magnetization alignment direction of the ferromagnetic structure.

The control circuit may be configured to change a magnetic flux of the frequency tunable device based on the reversal of the magnetization alignment direction.

The control circuit may be configured to obtain a resonant frequency corresponding to the changed magnetic flux using a model that defines the relationship between the magnetic flux and the resonant frequency.

For the controlling of the resonant frequency, the control circuit may be configured to control the resonant frequency in two states including coupling on and coupling off.

For the controlling of the resonant frequency, the control circuit may be configured to control the resonant frequency to be coupling-on frequency by setting the resonant frequency of the frequency tunable device to be similar to resonant frequencies of coupled qubits.

The frequency tunable device may include two Josephson junctions and the ferromagnetic structure is located between the two Josephson junctions or on an outer side of one of the two Josephson junctions.

The ferromagnetic structure may be formed with a structure in which horizontal symmetry is broken.

The ferromagnetic structure may have a diameter of 50 nanometers or more and 5 micrometers or less.

The first conductive pad and the second conductive pad may be made of a superconducting material.

The control line may be disposed in parallel to a longitudinal direction of the first conductive pad and the second conductive pad.

The control line may be made of a heavy metal.

The control line, the ferromagnetic structure, and the frequency tunable device may be stacked from bottom to top.

In one or more general aspects, a method of controlling a resonant frequency of a frequency tunable device using a superconducting device, the superconducting qubit-based device comprising a frequency tunable device including a first conductive pad and a second conductive pad that are connected to each other by a Josephson junction, a ferromagnetic structure disposed at a predetermined distance apart from the first and second conductive pads, and a control line located below the ferromagnetic structure, includes: applying current to the control line; reversing a magnetization alignment direction of the ferromagnetic structure; changing a magnetic flux of the frequency tunable device; and controlling a resonant frequency of the frequency tunable device.

The frequency tunable device may include either one or both of a tunable qubit coupler and a tunable qubit.

The reversing of the magnetization alignment direction may include reversing the magnetization alignment direction of the ferromagnetic structure by applying a current exceeding a predetermined threshold value to the control line to induce a SOT phenomenon in the ferromagnetic structure.

In one or more general aspects, a superconducting device includes: a frequency tunable device comprising two Josephson junctions, wherein a ferromagnetic structure is located between the two Josephson junctions or on an outer side of one of the two Josephson junctions; the ferromagnetic structure; and a control line, wherein a resonant frequency of the frequency tunable device is changed by reversing a magnetization alignment direction of the ferromagnetic structure by applying a current exceeding a predetermined threshold to the control line.

Other features and aspects will be apparent from the following detailed description, the drawings, and the claims.

### BRIEF DESCRIPTION OF THE DRAWINGS

FIG. 1A is a diagram illustrating a structure of a quantum computer chip according to one or more embodiments.
FIG. 1B is a circuit diagram illustrating a frequency-fixed device.
FIG. 1C is a circuit diagram illustrating a frequency tunable device.
FIG. 1D is a circuit diagram for describing a resonant frequency control of a tunable qubit coupler.
FIGS. 2A and 2B are diagrams illustrating a structure of a superconducting device including a tunable qubit coupler according one or more embodiments.
FIGS. 2C and 2D are diagrams illustrating a ferromagnetic structure according to one or more embodiments.
FIGS. 3A to 3D are circuit diagrams illustrating a magnetic field and a magnetic flux passing through a tunable qubit coupler according to a magnetization alignment direction of a ferromagnetic structure in accordance with one or more embodiments.
FIGS. 4A to 4B are circuit diagrams illustrating a magnetic field and a magnetic flux passing through a tunable qubit coupler according to a magnetization alignment direction of a ferromagnetic structure in accordance with one or more embodiments.
FIGS. 5A and 5B are graphs showing a relationship between an application of current and resonant frequency over time.
FIGS. 6A to 6D are diagrams illustrating a process of manufacturing a superconducting device according to one or more embodiments.
FIG. 7 is a flowchart illustrating a method of controlling a resonant frequency of a tunable qubit coupler using a superconducting device according to one or more embodiments.

Throughout the drawings and the detailed description, unless otherwise described, the same drawing reference numerals will be understood to refer to the same elements, features, and structures. The relative size and depiction of these elements may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences within and/or of operations described herein are merely examples, and are not limited to those set forth herein, but may be changed as will be apparent after an understanding of the disclosure of this application, except for sequences within and/or of operations necessarily occurring in a certain order. As another example, the sequences of and/or within operations may be performed in parallel, except for at least a portion of sequences of and/or within operations necessarily occurring in an order, e.g., a certain order. Also, descriptions of features that are known after an understanding of the disclosure of this application may be omitted for increased clarity and conciseness.

Reference will now be made in detail to embodiments, examples of which are illustrated in the accompanying drawings. Advantages and features of the present invention and methods of achieving the same will become apparent with reference to the embodiments described in detail below with reference to the accompanying drawings. Like reference numerals refer to like elements throughout the specification.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated features, numbers, operations, members, elements, and/or combinations thereof are not present.

In the following description, when a constituent element is disposed "above" or "below" another constituent element, the constituent element may be only directly on or below the other constituent element or above or below the other constituent elements in a non-contact manner.

TAs used herein, the term "and/or" includes any one and any combination of any two or more of the associated listed items. The phrases "at least one of A, B, and C", "at least one of A, B, or C", and the like are intended to have disjunctive meanings, and these phrases "at least one of A, B, and C", "at least one of A, B, or C", and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

The operations that constitute a method can be performed in any suitable order unless otherwise indicated herein. The use of any and all language (e.g., "such as") provided herein is intended merely to explain the disclosure in detail and does not pose a limitation on the scope of the disclosure unless otherwise claimed.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein.

Throughout the specification, when a component or element is described as "on," "connected to," "coupled to," or "joined to" another component, element, or layer, it may be directly (e.g., in contact with the other component, element, or layer) "on," "connected to," "coupled to," or "joined to" the other component element, or layer, or there may reasonably be one or more other components elements, or layers intervening therebetween. When a component or element is described as "directly on", "directly connected to," "directly coupled to," or "directly joined to" another component element, or layer, there can be no other components, elements, or layers intervening therebetween. Likewise, expressions, for example, "between" and "immediately between" and "adjacent to" and "immediately adjacent to" may also be construed as described in the foregoing.

As used herein, the term "and/or" includes any one and any combination of any two or more of the associated listed items. The phrases "at least one of A, B, and C", "at least one of A, B, or C", and the like are intended to have disjunctive meanings, and these phrases "at least one of A, B, and C", "at least one of A, B, or C", and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application. The use of the term "may" herein with respect to an example or embodiment (e.g., as to what an example or embodiment may include or implement) means that at least one example or embodiment exists where such a feature is included or implemented, while all examples are not limited thereto. The use of the terms "example" or "embodiment" herein have a same meaning (e.g., the phrasing "in one example" has a same meaning as "in one embodiment", and "one or more examples" has a same meaning as "in one or more embodiments").

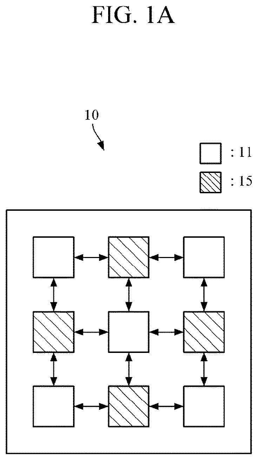

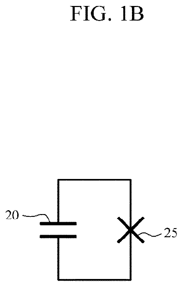

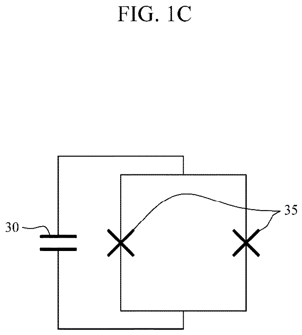

FIG. 1A is a diagram illustrating a structure of a quantum computer chip according to one or more embodiments. FIG. 1B is a circuit diagram illustrating a frequency-fixed device, for example, a fixed qubit or a fixed qubit coupler, and FIG. 1C is a circuit diagram illustrating a frequency tunable device, for example, a tunable qubit or a tunable qubit coupler.

Referring to FIG. 1A, inside a quantum computer chip 10, there are multiple qubits 11 along with qubit couplers 15 connecting the qubits to each other. The qubit couplers 15 may be used to perform quantum entanglement and other interactions between qubits. In the quantum computer chip 10, when there are two or more qubits 11 present, qubit couplers 15 may be used for facilitating interactions between these qubits.

The qubits 11 may be classified into fixed qubits with a fixed resonant frequency and tunable qubits with a tunable resonant frequency. Similarly, the qubit couplers 15 may be classified into fixed qubit couplers with a fixed resonant frequency and tunable qubit couplers with an adjustable resonant frequency.

Fixed qubits and fixed qubit couplers may be formed, for example, with one capacitor 20 and one Josephson junction 25 (e.g., as shown in FIG. 1B). On the other hand, tunable qubits and tunable qubit couplers may be formed, for example, with one capacitor 30 and two Josephson junctions 35 (e.g., as shown in FIG. 1C).

For example, qubits and couplers may have the same structure, and they may be selected and used as either qubits or couplers depending on the purpose.

Furthermore, tunable qubits may set a desired or determined resonant frequency by tuning the resonant frequency, and tunable qubit couplers may control the turning on/off of quantum entanglement of qubits by tuning the resonant frequency to two different values.

In the following embodiments using a ferromagnetic structure, the utilization of two states of magnetization within a ferromagnetic material (e.g., alignment in the upward direction and alignment in the downward direction) may make tunable qubit couplers more useful than tunable qubits. Therefore, the description will focus on tunable qubit couplers, as a non-limiting example.

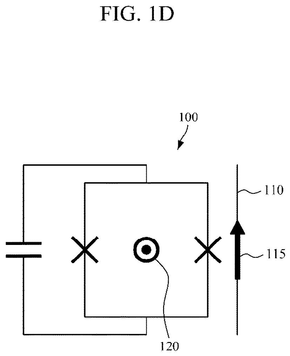

FIG. 1D is a circuit diagram for describing a resonant frequency control of a tunable qubit coupler.

Fixed qubit couplers may maintain a fixed resonant frequency, which must closely match the resonant frequencies of the coupled qubits to enable interactions between the qubits. In this example, due to the fixed resonant frequency of the coupler, the coupled qubits may always engage in mutual interactions.

In contrast, tunable qubit couplers may tune the resonant frequency to either enable substantial interaction between qubits (e.g., coupling on) or minimize interaction between qubits (e.g., coupling off). For example, tunable qubit couplers may be configured to increase qubit interaction by tuning the coupler's resonant frequency to closely match the resonant frequencies of the coupled qubits (e.g., coupling on). Conversely, the tunable qubit couplers may also be configured to significantly reduce qubit interaction by setting the coupler's resonant frequency differently from that of the coupled qubits (e.g., coupling off).

That is, the tunable qubit couplers may freely enable and disable interactions between qubits, allowing for more effective quantum computing compared to fixed qubit couplers.

Referring to FIG. 1D, a typical tunable qubit coupler 100 may use a separate control line 110 adjacent to the coupler for resonant frequency control. When a control current (e.g., bias current) 115 is applied to the control line by the control circuit, a magnetic field 120 may be generated around the control line (e.g., generated in the vertical upward direction (⊙) as per Ampere's right-handed screw rule). This generated magnetic field 120 may change the magnetic flux passing through the coupler, and the resonant frequency may change accordingly. For example, by adjusting the magnitude and direction of the control current, the resonant frequency of the coupler may be controlled.

However, the typical tunable qubit coupler 100 has drawbacks in that a relatively high constant control current of several milliamperes (mA) may need to be continuously applied while the qubit coupler is in operation, a separate cryogenic electronic device may be required to apply direct current (DC) control current, and magnetic noise (flux noise) and crosstalk caused by DC current may disrupt stable quantum computing.

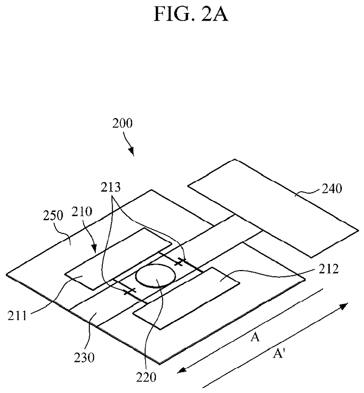

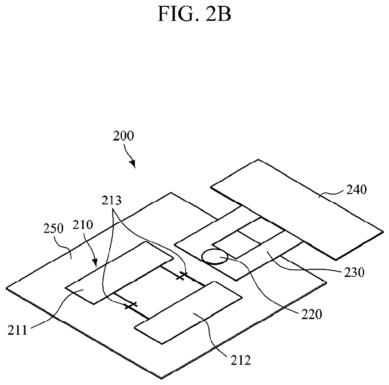

FIGS. 2A and 2B are diagrams illustrating a structure of a superconducting device including a tunable qubit coupler according one or more embodiments.

Referring to FIGS. 2A and 2B, a superconducting device 200 may include a tunable qubit coupler 210, a ferromagnetic structure 220, a control line 230, and a control circuit 240.

The tunable qubit coupler 210 may be positioned between qubits and may act as a coupler that can turn on/off the interaction between qubits by adjusting the resonant frequency. It may include a first conductive pad 211 and a second conductive pad 212 that are connected to each other via Josephson junctions 213.

The Josephson effect may refer to a phenomenon in which current flows through a thin insulator when placed between, for example, two superconducting materials. The Josephson junction 213 may signify a weak link between two superconducting materials bonded with an insulator. In this example, various types of metals may be used in addition to insulators as materials for the weak link to form the Josephson junction 213.

The first conductive pad 211 and the second conductive pad 212 may each be formed of a superconducting material and disposed on a substrate 250. In this example, both the first conductive pad 211 and the second conductive pad 212 may be formed from the same superconducting material or different superconducting materials. The superconducting material may include at least one of aluminum (Al), niobium (Nb), indium (In), alpha-tantalum (α-Ta), titanium (Ti), lead (Pb), vanadium (V), and/or compounds thereof (e.g., NbN, NbTiN, TiN, or VN), but is not limited thereto.

The ferromagnetic structure 220 may be disposed at a predetermined distance apart from the first conductive pad 211 and the second conductive pad 222.

A ferromagnetic material may refer to a substance in which the magnetic moments or magnetizations of atoms are aligned in a specific direction even in the absence of an external magnetic field. Magnetizations in a ferromagnetic material may be oriented in a specific preferred direction, which is called magnetic anisotropy. For example, in the example of a ferromagnetic thin film, when the ferromagnetic thin film has perpendicular magnetic anisotropy, the magnetization of the ferromagnetic thin film may prefer alignment in the perpendicular direction (e.g., +Z or -Z axis direction). When the ferromagnetic thin film has in-plane magnetic anisotropy, the magnetization may prefer alignment in the horizontal direction (e.g., XY plane direction).

The ferromagnetic structure 220 may have characteristics of the ferromagnetic material (ferromagnet), and may be formed of a ferromagnet (e.g., Co, CoFeB, (CoNi)n, (CoPt)n, and/or the like), not only in its pure form but also in a heterojunction structure with the ferromagnet and heavy metals (e.g., platinum (Pt), tantalum (Ta), palladium (Pd), tungsten (W), ruthenium (Ru), etc.), and even with an antiferromagnetic material (e.g., antiferromagnet). The types of ferromagnetic structure 220 are not limited thereto.

The diameter of the ferromagnetic structure 220 may range from tens of nanometers to several micrometers (e.g., from 50 nm to 5 µm), and there are no restrictions on the shape of the ferromagnetic structure 220, which may include a cylindrical shape as well as a cuboid, a rectangle, and/or the like.

Referring to FIG. 2A, the tunable qubit coupler 210 includes two Josephson junctions 213, and the ferromagnetic structure 220 may be positioned between the two Josephson junctions 213. Referring to FIG. 2B, the ferromagnetic structure 220 may be located on the outer side of one of the Josephson junctions 213 adjacent to the control circuit 240. In this example, the ferromagnetic structure 220 may be disposed at a distance, for example, from the first conductive pad 211, the second conductive pad 212, and/or the Josephson junction 213, within the range of tens to hundreds of nanometers to allow the magnetic flux of the tunable qubit coupler 210 to be changed. The arrangement of the ferromagnetic structure 220 is not limited to this example.

The control line 230 may be a wire through which control current flows under the control of the control circuit 240 and may be positioned below the ferromagnetic structure 220. The control line 230 may be disposed between the first conductive pad 211 and the second conductive pad 212 in parallel to the longitudinal direction thereof and connected to the control circuit 240 (e.g., as shown in FIG. 2A). Additionally or alternatively, the control line 230 may be positioned at a predetermined distance apart from the first conductive pad 211 and the second conductive pad 212 and connected to the control circuit 240 (e.g., as shown in FIG. 2B).

The control line 230 may be made of a material that exhibits a significant spin-hall effect, such as Ta, Pt, Pd, W, Ru, and/or the like, but it is not limited to these materials. The size of the control line 230 may range, for example, from tens of nanometers to tens of micrometers.

The control circuit 240 may be connected to the control line 230 and may control the current flowing through the control line 230, thereby regulating the resonant frequency of the tunable qubit coupler 210.

First, the control circuit 240 may induce the spin-orbit torque (SOT) phenomenon in the ferromagnetic structure 220 by applying current to the control line 230, thereby reversing the magnetization alignment direction of the ferromagnetic structure 220.

The spin-orbit torque (SOT) phenomenon may refer to a phenomenon where, when a current exceeding a predetermined threshold value is applied to a bilayer composed of a heavy metal and a ferromagnetic structure, the current exerts a torque on the magnetization of the ferromagnetic structure, causing magnetization switching. For example, the control circuit 240 may induce the SOT phenomenon in the ferromagnetic structure 220 located above the control line 230 by applying a current exceeding a predetermined threshold value to the control line 230, thereby reversing the magnetization alignment direction by 180 degrees, such as from vertical upward to downward direction or from vertical downward to upward.

To reverse the formed magnetization alignment direction of the ferromagnetic structure, the control circuit 240 may apply a current exceeding a predetermined threshold value in the opposite direction to the direction of the current during the formation of the magnetization alignment direction.

Referring back to FIG. 2A, when the current flows in direction A through the control line 230 and induces the SOT phenomenon in the ferromagnetic structure 220 to form a vertical upward magnetization alignment direction, the control circuit 240 may apply a current exceeding a predetermined threshold value in the opposite direction, A', to the control line 230. As a result, the SOT phenomenon may be induced and the magnetization alignment direction may be reversed to a vertical downward direction. Information regarding the current direction based on the magnetization alignment direction and the predetermined threshold value may be stored in an internal or external storage unit, and the control circuit 240 may use the stored information to apply the current.

In this example, to reverse the magnetization alignment direction via the SOT phenomenon depending on the direction of the current applied to the ferromagnetic structure 220, the ferromagnetic structure 220 may break the horizontal symmetry. For this purpose, a separate form may be used for the ferromagnetic structure 220. Alternatively, an external factor such as a magnetic field may be applied to the ferromagnetic structure 220.

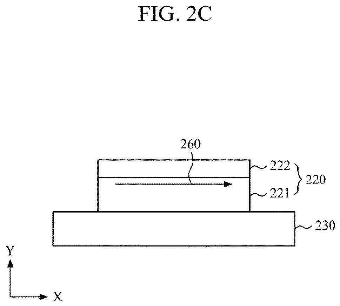

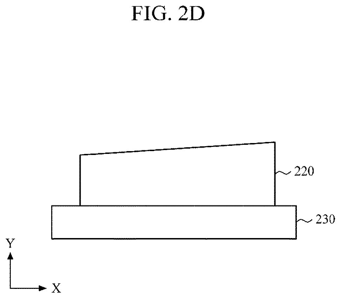

FIGS. 2C and 2D are diagrams illustrating a ferromagnetic structure with broken horizontal symmetry according to one or more embodiments.

Referring to FIG. 2C, when a ferromagnetic structure 220 is formed by bonding an antiferromagnetic material 222 to the top of a ferromagnetic material 221 above a control line 230, the antiferromagnetic material 222 may generate a localized horizontal (X-direction) magnetic field 260 on the ferromagnetic material 221, breaking horizontal (X-direction) symmetry of the ferromagnetic structure 220. Referring to FIG. 2D, even when the thickness (Y-direction) of the ferromagnetic structure 220 itself varies horizontally (X-direction), it may also break the horizontal (X-direction) symmetry of the ferromagnetic structure 220. However, the form of the ferromagnetic structure 220 that breaks the horizontal symmetry is not limited to these examples.

Furthermore, the control circuit 240 may reverse the magnetization alignment direction by applying a current exceeding a predetermined threshold value to the control line 230 only once. Since the magnetization of the ferromagnetic structure 220 remains unchanged even when the external magnetic field is eliminated, the control circuit 240 may reverse the magnetization alignment direction by applying a current exceeding a predetermined threshold value only once without the need for continuous application and may maintain the reversed magnetization alignment direction. In this example, the control circuit 240 may apply the current exceeding the predetermined threshold value in the form of a pulse, for example.

Then, the control circuit 240 may change the flux of the tunable qubit coupler 210 based on the reversal of the magnetization alignment direction of the ferromagnetic structure 220.

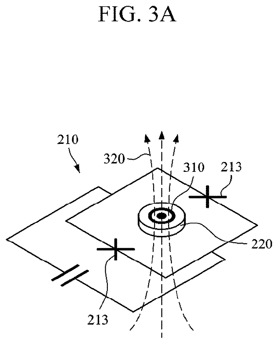

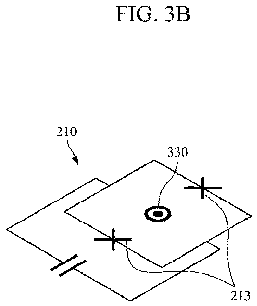

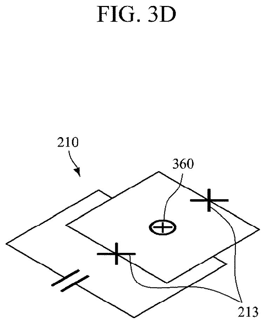

FIGS. 3A to 3D are circuit diagrams illustrating a magnetic field and a magnetic flux passing through a tunable qubit coupler according to a magnetization alignment direction of a ferromagnetic structure in accordance with one or more embodiments. FIGS. 3A to 3D illustrates one or more embodiments where the ferromagnetic structure 220 of FIG. 2A is positioned between the Josephson junctions 213 in a superconducting device.

Referring to FIGS. 3A to 3B, when the control circuit 240 applies current to the control line 230, aligning the magnetization of the ferromagnetic structure 220 in the vertical upward direction (⊙) 310, the ferromagnetic structure 220 may emit a magnetic field 320 in the vertical upward direction, similar to a bar magnet with the north pole facing vertically upwards. As a result, a magnetic flux 330 in the vertical upward direction may be formed in the tunable qubit coupler 210.

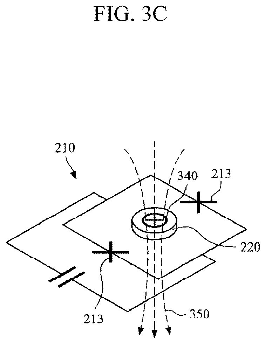

Referring to FIGS. 3C to 3D, when the control circuit 240 applies current to the control line 230, aligning the magnetization of the ferromagnetic structure 220 in the vertical downward direction (⊗) 340, the ferromagnetic structure 220 may emit a magnetic field 350 in the vertical downward direction, similar to a bar magnet with the north pole facing vertically downwards. Consequently, a magnetic flux 360 in the vertical downward direction may be formed in the tunable qubit coupler 210.

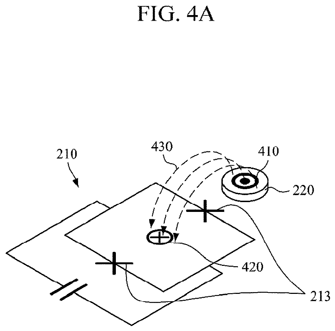

FIGS. 4A to 4B are circuit diagrams illustrating a magnetic field and a magnetic flux passing through a tunable qubit coupler according to a magnetization alignment direction of a ferromagnetic structure in accordance with one or more embodiments. FIGS. 4A to 4B illustrate one or more embodiments where the ferromagnetic structure 220 of FIG. 2B is located outside the Josephson junction 213 in a superconducting device.

Referring to FIG. 4A, when current flows through the control line 230, aligning the magnetization of the ferromagnetic structure 220 in the vertical upward direction (⊙) 410, the ferromagnetic structure 220 may emit a magnetic field 430 in the vertical upward direction from the top thereof, similar to a bar magnet with the north pole pointing vertically upwards. The emitted magnetic field 430 may pass through the space between the Josephson junctions of the tunable qubit coupler 210 and curve downward in a parabolic trajectory toward the lower part, ultimately forming a magnetic flux 420 in the vertical downward direction in the tunable qubit coupler 210.

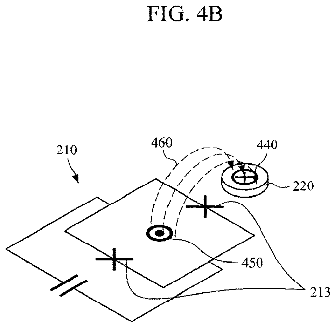

Referring to FIG. 4B, when current flows through the control line 230, aligning the magnetization of the ferromagnetic structure 220 in the vertical downward direction (⊗) 440, the ferromagnetic structure 220 may emit a magnetic field 460 in the vertical downward direction, similar to a bar magnet with the north pole facing vertically downwards. The emitted magnetic field 460 may curve upward in a parabolic trajectory toward the top of the ferromagnetic structure 220 and pass through the space between the Josephson junctions of the tunable qubit coupler 210, ultimately forming a magnetic flux 450 in a vertical upward direction in the tunable qubit coupler 210.

Next, the control circuit 240 may obtain a resonant frequency corresponding to the magnetic flux changed according to the magnetization alignment direction using a model that defines the relationship between magnetic flux and resonant frequency.

The resonant frequency of the coupler may change with the magnetic flux that passes through the coupler. Thus, a model that defines the relationship between resonant frequency and magnetization may be generated. The control circuit 240 may use the generated model to acquire the resonant frequency based on the magnetization generated according to the magnetization alignment direction. The model that defines the relationship between resonant frequency and magnetic flux may be pre-constructed through regression analysis or machine learning and stored in internal or external storage. The control circuit 240 may utilize the stored model to obtain the resonant frequency based on the magnetic flux.

At this time, the control circuit 240 may control the resonant frequency in two states: coupling on and coupling off.

In the ferromagnetic structure 220 including a ferromagnetic material, due to the characteristics of a ferromagnetic material, when the magnetization alignment direction remains unchanged due to the application of a current exceeding a predetermined threshold value, the magnitude of the magnetic field may remain constant over time. Consequently, the magnetization of the tunable qubit coupler 210 may remain constant, resulting in a constant resonant frequency.

When the magnetization alignment direction of the ferromagnetic structure 220, according to the above-described embodiment, only has two directions due to the reversal (e.g., vertical upward and vertical downward directions) then there may be only two constant resonant frequencies. One of these values may be used as the coupling-on frequency at which qubit interactions are formed, and the other may be used as the coupling-off frequency at which qubit interactions are not formed. In this example, a resonant frequency similar to the resonant frequencies of the coupled qubits and the tunable qubit coupler may be used as the coupling-on frequency, and a resonant frequency that relatively differs from the resonant frequencies of the qubits may be used as the coupling-off frequency.

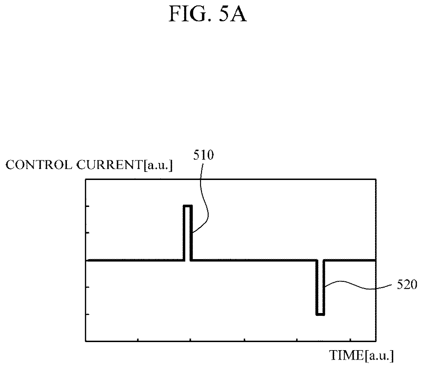

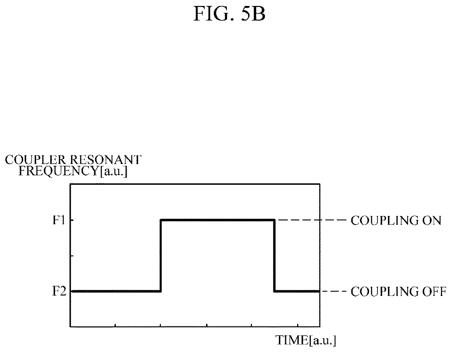

FIGS. 5A and 5B are graphs showing a relationship between an application of current and resonant frequency over time.

Referring to FIGS. 5A and 5B, the control circuit 240 may obtain a coupling-on frequency F1 by controlling a current, for example, applying a current exceeding a threshold value in the form of a pulse 510. Similarly, the control circuit 240 may obtain a coupling-off frequency F2 by applying a current exceeding the threshold value in the form of a pulse in the opposite direction 520. For example, the control circuit 240 may apply a current in the form of a pulse only when a change in coupling state is determined as needed.

According to the above-described embodiment, the control circuit 240 may induce SOT in the ferromagnetic structure 220 by applying a predetermined current to the control line 230, thereby reversing the magnetization alignment direction of the ferromagnetic structure 220. The control circuit 240 may also change the magnetic flux of the tunable qubit coupler 210 according to the reversal of the magnetization alignment direction and use a model that defines the relationship between magnetic flux and resonant frequency to obtain the resonant frequency corresponding to the changed magnetic flux. That is, the control circuit 240 of one or more embodiments may ultimately control the resonant frequency of the tunable qubit coupler 210 by controlling the current.

According to one embodiment, a superconducting device, including a tunable qubit coupler, may exist in a layered structure. For example, the superconducting device may be formed as a layered structure in which a control line, a ferromagnetic structure, and a frequency tunable device (e.g., a tunable qubit coupler) are stacked from bottom to top.

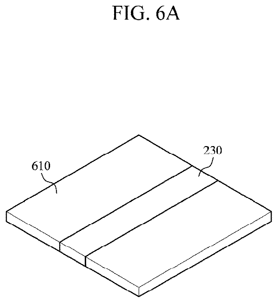

FIGS. 6A to 6D are diagrams illustrating a process of manufacturing a superconducting device according to one or more embodiments.

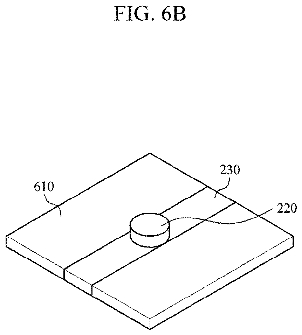

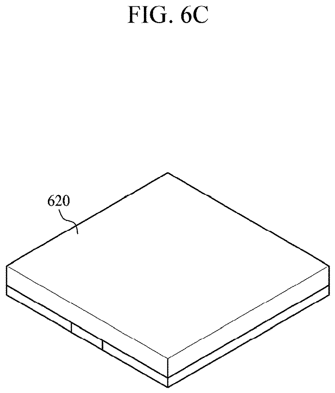

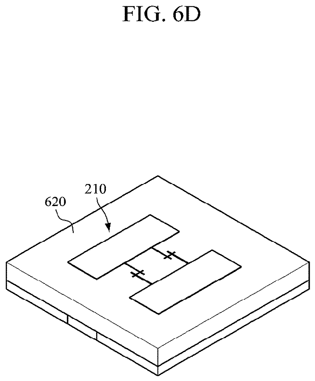

Referring to FIGS. 6A to 6D, first, a control line 230 may be disposed on a substrate 610 (as shown in FIG. 6A), and a ferromagnetic structure 220 may be disposed on top of the conductive line 230 (as shown in FIG. 6B). Then, an insulating layer 620 made of an insulating material may be disposed (as shown in FIG. 6C), and finally a tunable qubit coupler 210 may be disposed (as shown in FIG. 6D).

As described above, the tunable qubit coupler and the tunable qubit, which are frequency tunable devices, may have the same structure, and thus, depending on the intended use, they may be selected as either the coupler or the qubit. Therefore, the above embodiment may be employed as a tunable qubit.

For example, a ferromagnetic structure may be placed between positive conductive pads of the tunable qubit and at a predetermined distance from a Josephson junction. A control line may be disposed below the ferromagnetic structure, and the current flowing through the control line may be controlled by a control circuit to adjust the resonant frequency of the tunable qubit.

A typical tunable qubit coupler may be driven by a volatile control method in which a continuous control current needs to be applied to maintain a desired resonant frequency. This typical tunable qubit coupler may be inefficient in terms of energy consumption, and may lead to reduced reliability in the measured resonant frequency due to noise (e.g., magnetic noise) and cross-talk caused by the control current, resulting in reduced stability in quantum computing accordingly. Additionally, for the typical tunable qubit coupler, a separate cryogenic electronic device (e.g., cryogenic DC lines) may be required to supply the control current.

In contrast to the typical tunable qubit coupler, according to one or more embodiments of controlling the resonant frequency of the tunable qubit coupler using the magnetic field generated by the ferromagnetic structure, the magnetization alignment direction of the ferromagnetic structure may remain constant, and consequently, the resonant frequency of the coupler may remain constant as well. Therefore, continuous control current supply is not necessary.

To change the resonant frequency, the device and method of one or more embodiments only needs to apply a current exceeding a threshold value (for example, in the form of a pulse) once (non-volatile control method). This, the device and method of one or more embodiments may reduce issues related to noise and cross-talk caused by continuous control current supply, reduce costs and complexity associated with the need for a separate electronic device, and enable relatively stable resonant frequency control.

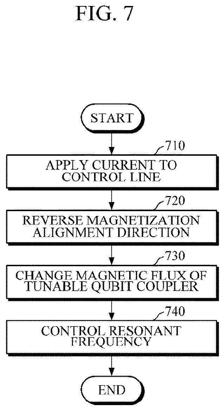

FIG. 7 is a flowchart illustrating a method of controlling a resonant frequency of a tunable qubit coupler using a superconducting device according to one or more embodiments. Operations 710 to 740 described below may be performed in the order and manner as shown and described below with reference to FIG. 7, but the order of one or more of the operations may be changed, one or more of the operations may be omitted, and/or two or more of the operations may be performed in parallel or simultaneously without departing from the scope of the example embodiments described herein.

FIG. 7 illustrates one or more embodiments of a method of controlling the resonant frequency of the tunable qubit coupler according to the embodiments of FIGS. 1 to 6D. To avoid redundancy, a brief description is provided.

In this example, the superconducting device may include a tunable qubit coupler with first and second conductive pads connected by Josephson junctions, a ferromagnetic structure disposed at a predetermined distance apart from the first and second conductive pads, and a control line located below the ferromagnetic structure. The ferromagnetic structure may be formed in a structure in which horizontal symmetry is broken.

First, the superconducting device may apply current to the control line in 710.

The control line may be made of a heavy metal and may be arranged parallel to the longitudinal direction of the first and second conductive pads or spaced at a predetermined distance from the first and second conductive pads. In this example, the superconducting device may apply a current exceeding a predetermined threshold value to the control line in the form of a pulse only once.

When the current is applied to the control line in 710, the superconducting device may reverse the magnetization alignment direction of the ferromagnetic structure in 720. For example, the superconducting device may induce the SOT phenomenon in the ferromagnetic structure by applying the current exceeding the predetermined threshold value to the control line, thus reversing the magnetization alignment direction of the ferromagnetic structure. In this example, the superconducting device may reverse the magnetization alignment direction by applying the current exceeding the predetermined threshold value in the opposite direction of the current during the formation of the magnetization alignment direction.

When the magnetization alignment direction of the ferromagnetic structure is reversed in 720, the superconducting device may change a magnetic flux of the tunable qubit coupler according to the reversed magnetization alignment direction of the ferromagnetic structure in 730, and may control the resonant frequency of the tunable qubit coupler in 740. For example, the superconducting device may obtain the resonant frequency corresponding to the magnetic flux changed according to the magnetization alignment direction using a model that defines the relationship between magnetic flux and resonant frequency. In this example, the superconducting device may control the resonant frequency in two states: coupling on and coupling off.

The quantum computer chips, qubits, qubit couplers, capacitors, Josephson junctions, control lines, superconducting devices, first conductive pads, second conductive pads, ferromagnetic structures, control circuits, substrates, ferromagnetic materials, insulating layers, quantum computer chip 10, qubits 11, qubit couplers 15, capacitor 20, Josephson junction 25, capacitor 30, Josephson junctions 35, tunable qubit coupler 100, control line 110, superconducting device 200, tunable qubit coupler 210, first conductive pad 211, second conductive pad 212, Josephson junctions 213, ferromagnetic structure 220, control line 230, control circuit 240, substrate 250, second conductive pad 222, ferromagnetic material 221, substrate 610, insulating layer 620 described herein, including descriptions with respect to respect to FIGS. 1-7, are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in, and discussed with respect to, FIGS. 1-7 that perform the operations described in this application are performed by computing hardware, for example, by one or more processors or computers, implemented as described above implementing instructions (e.g., computer or processor/processing device readable instructions) or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks , and/or any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above and all drawing disclosures, the scope of the invention is defined by the enclosed claims.

## Claims

1. A superconducting device comprising:
a frequency tunable device comprising a first conductive pad and a second conductive pad that are connected to each other by a Josephson junction;
a ferromagnetic structure disposed at a predetermined distance apart from the first and second conductive pads;
a control line located below the ferromagnetic structure; and
a control circuit configured to control a resonant frequency of the frequency tunable device by controlling current flowing through the control line.

2. The superconducting device of claim 1, wherein the frequency tunable device comprises either one or both of a tunable qubit coupler and a tunable qubit.

3. The superconducting device of claim 1 or 2, wherein the control circuit is configured to reverse a magnetization alignment direction of the ferromagnetic structure by applying a current exceeding a predetermined threshold to the control line to induce a spin-orbit torque, SOT, phenomenon in the ferromagnetic structure.

4. The superconducting device of claim 3, wherein, for the applying of the current exceeding the predetermined threshold, the control circuit is configured to apply the current exceeding the predetermined threshold in the form of a pulse only once, and
wherein, for the applying of the current exceeding the predetermined threshold, the control circuit is further configured to apply the current exceeding the predetermined threshold value in an opposite direction to a direction of a current during the formation of the magnetization alignment direction to reverse the formed magnetization alignment direction of the ferromagnetic structure.

5. The superconducting device of claim 3, wherein the control circuit is configured to change a magnetic flux of the frequency tunable device based on the reversal of the magnetization alignment direction, and
wherein the control circuit is further configured to obtain a resonant frequency corresponding to the changed magnetic flux using a model that defines the relationship between the magnetic flux and the resonant frequency.

6. The superconducting device of claim 3, wherein, for the controlling of the resonant frequency, the control circuit is configured to control the resonant frequency in two states including coupling on and coupling off, and
wherein, for the controlling of the resonant frequency, the control circuit is further configured to control the resonant frequency to be coupling-on frequency by setting the resonant frequency of the frequency tunable device to be similar to resonant frequencies of coupled qubits.

7. The superconducting device of one of claims 1 to 6, wherein the frequency tunable device comprises two Josephson junctions and the ferromagnetic structure is located between the two Josephson junctions or on an outer side of one of the two Josephson junctions.

8. The superconducting device of one of claims 1 to 7, wherein the ferromagnetic structure is formed with a structure in which horizontal symmetry is broken.

9. The superconducting device of one of claims 1 to 8, wherein a magnetic field is applied to the ferromagnetic structure to break a horizontal symmetry.

10. The superconducting device of one of claims 1 to 9, wherein the first conductive pad and the second conductive pad are made of a superconducting material.

11. The superconducting device of one of claims 1 to 10, wherein the control line is disposed in parallel to a longitudinal direction of the first conductive pad and the second conductive pad, or
wherein the control line is made of a heavy metal, or
wherein the control line, the ferromagnetic structure, and the frequency tunable device are stacked from bottom to top.

12. A method of controlling a resonant frequency of a frequency tunable device using a superconducting device, the superconducting device comprising a frequency tunable device including a first conductive pad and a second conductive pad that are connected to each other by a Josephson junction, a ferromagnetic structure disposed at a predetermined distance apart from the first and second conductive pads, and a control line located below the ferromagnetic structure, the method comprising:
applying current to the control line;
reversing a magnetization alignment direction of the ferromagnetic structure;
changing a magnetic flux of the frequency tunable device; and
controlling a resonant frequency of the frequency tunable device.

13. The method of claim 12, wherein the frequency tunable device comprises either one or both of a tunable qubit coupler and a tunable qubit.

14. The method of claim 13, wherein the reversing of the magnetization alignment direction comprises reversing the magnetization alignment direction of the ferromagnetic structure by applying a current exceeding a predetermined threshold value to the control line to induce a SOT phenomenon in the ferromagnetic structure.

15. A superconducting device comprising:
a frequency tunable device comprising two Josephson junctions, wherein a ferromagnetic structure is located between the two Josephson junctions or on an outer side of one of the two Josephson junctions;
the ferromagnetic structure; and
a control line,
wherein a resonant frequency of the frequency tunable device is changed by reversing a magnetization alignment direction of the ferromagnetic structure by applying a current exceeding a predetermined threshold to the control line.
